# EUROPÄISCHE PATENTSCHRIFT

(11) **EP 1 118 928 B1**
(45) Veröffentlichungstag und Bekanntmachung des Hinweises auf die Patenterteilung: **01.02.2012**
(21) Anmeldenummer: 00126001.7
(22) Anmeldetag: 28.11.2000
(51) Int. Cl.: G06F 1/26, G05F 1/46

(54) **Schaltungsanordnung zur Regelung des Leitungsverbrauchs eines integrierten Schaltkreises**
Circuit for controlling the power consumption of an integrated circuit
Circuit de régulation de la consommation d'énergie d'un circuit intégré

(30) Priorität: 30.12.1999 DE 19963813
(43) Veröffentlichungstag der Anmeldung: 25.07.2001
(73) Patentinhaber: Qimonda AG, 81739 München (DE)
(72) Erfinder: Pöchmüller, Peter, Dr., 81739 München (DE)
(74) Vertreter: Epping - Hermann - Fischer

(56) Entgegenhaltungen:
- WO-A-96/19764
- DE-A- 2 207 735
- GB-A- 716 278
- GB-A- 1 231 904

## Beschreibung

Die vorliegende Erfindung betrifft eine Schaltungsanordnung zur Regelung des Leistungsverbrauchs eines integrierten Schaltkreises.

Integrierte Schaltkreise werden durch eine Versorgungsspannung mit Energie versorgt, wobei ein Strom in den integrierten Schaltkreis fließt. Die Leistungsaufnahme, sowie die Versorgungsspannung und der aufgenommene Strom integrierter Schaltkreise sind in der Vergangenheit einer Veränderung unterworfen gewesen. So ist beispielsweise die Betriebsspannung von Prozessoren von 5 Volt auf 3,3 Volt herabgesetzt worden.

Für die zukünftige Entwicklung integrierter Schaltkreise wird eine Entwicklung gemäß der International Technology Roadmap for Semiconductors, 1999 Edition, Overall Roadmap Technology Characteristics & Glossary (SIA Roadmap) erwartet.

Bei der SIA Roadmap (Semiconductor Industrie Association) handelt es sich um die prognostizierte und erwartete zukünftige Entwicklung der Mikroelektronik, wie sie von einem Konsortium von Firmen gesehen wird.

Ein Vergleich zwischen heute (1999) und dem Jahre 2011 ist in der folgenden Tabelle dargestellt.

| Jahr, Technologie | 1999, 180nm | 2011, 50nm |
|---|---|---|
| Minimale Versorgungsspannung für Logik VDD / Volt | 1,8 | 0,6 |
| Leistungsverbrauch / Watt | 90 | 174 |
| Stromverbrauch / Ampere | 50 | 290 |

Daraus folgt, dass im Jahre 2011 ein Strom von 290 Ampere bei einer Versorgungsspannung von 0,6 Volt erwartet wird. 290 Ampere sind dabei als sehr großer Stromwert anzusehen. Es stellt sich die Frage, wie 290 Ampere in einen integrierten Schaltkreis eingeprägt werden können, da die heutige elektrische Verdrahtung aufgrund von Elektromigration lediglich 1 Ampere pro Bond-Draht tragen kann. Bei der Lösung dieses Problems hilft die große Anzahl von elektrischen Anschlüssen, die in der Größenordnung von 10,000 Stück liegen wird.

Ein weiteres Problem stellt die Kontrolle des Systemrauschens dar. Wird zum Beispiel ein integrierter Schaltkreis von einem Ruhezustand, bei dem die Aktivität des integrierten Schaltkreises gering ist und daher der aufgenommene Strom ebenfalls klein ist, in einem Zustand hoher Aktivität versetzt, führt dies zu einem Stromsprung auf der Versorgungsleitung von circa 290 Ampere, der kontrolliert werden muss. Selbst bei einem geringen Leistungswiderstand der Stromzuführung von nur 0,01 mΩ, kommt es bei einem Stromsprung von 100 Ampere zu einem Spannungsabfall von einem Volt. Ein Spannungsabfall dieser Größenordnung ist unakzeptabel, und unmöglich, wenn der integrierte Schaltkreis mit nur 0,6 Volt Versorgungsspannung betrieben wird.

Typischerweise werden Schwankungen der Versorgungsspannung in einem Bereich von 10% der Versorgungsspannung toleriert.

Aus WO 96/19764 ist ein Computersystem bekannt, das den Stromverbrauch eines elektronischen Bauteils in unterschiedlichen Betriebszuständen des Bauteils misst und speichert, um den durchschnittlichen Stromverbrauch des Bauteils zu errechnen.

Es ist die Aufgabe der Erfindung, die von einer Spannungsquelle gesehene Leistungsaufnahme einer Schaltungsanordnung zumindest zeitweise im Wesentlichen gleichförmig zu gestalten.

Erfindungsgemäß wird die gestellte Aufgabe durch eine Schaltungsanordnung zur Regelung des Leistungsverbrauchs eines integrierten Schaltkreises gemäß Anspruch 1 gelöst.

Der Vorteil der erfindungsgemäßen Lösung besteht in der gleichmäßigen Leistungsaufnahme des integrierten Schaltkreises, wie sie von der Spannungsquelle wahrgenommen wird. In vorteilhafter Weise wird dieses Verhalten durch einen Leistungsverbraucher ermöglicht, der parallel zu dem integrierten Schaltkreis Leistung aufnimmt, wenn der integrierte Schaltkreis weniger Leistung verbraucht, so dass die Kombination aus integriertem Schaltkreis und Leistungsverbraucher eine annähernd konstante Leistung aufnimmt.

Erfindungsgemäß ist vorgesehen, dass der Leistungsverbraucher so gesteuert wird, dass der Leistungsverbrauch der Kombination aus integriertem Schaltkreis und Leistungsverbraucher im Wesentlichen konstant ist. Durch diese Regelmaßnahme wird erreicht, dass die Leistungsaufnahme der Kombination aus integriertem Schaltkreis und Leistungsverbraucher zumindest zeitweise im Wesentlichen konstant ist. Dadurch werden Stromspitzen und Stromeinbrüche auf der Versorgungsleitung vermieden.

Erfindungsgemäß ist ferner vorgesehen, dass der Leistungsverbraucher mehr Leistung aufnimmt, wenn der integrierte Schaltkreis weniger Leistung aufnimmt. Durch dieses Vorgehen wird die Leistung, die nicht von dem integrierten Schaltkreis verbraucht wird, von dem Leistungsverbraucher aufgenommen und es werden ebenfalls Stromspitzen und Stromeinbrüche auf den Versorgungsleitungen vermieden.

Eine vorteilhafte Ausprägung der Erfindung sieht vor, dass der Leistungsverbraucher elektrische Energie in Wärmeenergie umwandelt. Durch diese Anordnung wird die überschüssige Leistung verbraucht.

Eine weitere vorteilhafte Ausprägung der Erfindung sieht vor, daß während einer Zeitdauer mit im wesentlichen konstanter Leistungsaufnahme des Leistungsverbrauchers die Leistungsaufnahme des Leistungsverbrauchers verringert wird. Dadurch ist es möglich, die Leistungsaufnahme der Kombination aus integriertem Schaltkreis und Leistungsverbraucher in Zeiten geringer Aktivität, in denen der Leistungsverbraucher einen großen Teil der Leistung aufnimmt, herabzusetzen. Dies wird vorzugsweise mit einer Zeitkonstante durchgeführt, die groß ist im Vergleich zu dem Kehrwert einer Arbeitsfrequenz des integrierten Schaltkreises. Dadurch wird die Gesamtleistungsaufnahme der Kombination aus integriertem Schaltkreis und Leistungsverbraucher verringert, was die Betriebsdauer einer Batteriebetriebenen Schaltung verlängert. Weiterhin wird die Leistungsaufnahme des Leistungsverbrauchers nicht ganz auf null heruntergefahren, damit ein Vorhalt für einen Mehrverbrauch des integrierten Schaltkreises vorhanden ist, der sofort bereitsteht, wenn der integrierte Schaltkreis mehr Leistung aufnimmt.

Eine weitere vorteilhafte Ausprägung sieht vor, daß der Leistungsverbraucher, die Leistungsverbrauchersteuerung und/oder eine Leistungsverbraucherregelung in dem integrierten Schaltkreis angeordnet ist. Dadurch ist eine kompakte Bauweise ermöglicht, die keinen zusätzlichen Aufwand außerhalb des integrierten Schaltkreises erfordert.

Eine weitere vorteilhafte Ausführung der Erfindung sieht vor, daß der Leistungsverbraucher einen steuerbaren Widerstand, einen Transistor, einen Kondensator und/oder einen weiteren integrierten Schaltkreis umfaßt. Ein Transistor kann beispielsweise als Feldeffekttransistor oder Bipolartransistor ausgebildet sein und kann mit Schaltungselementen wie Widerständen, Kondensatoren und Spulen verschaltet sein. Weiterhin ist es vorteilhaft, den Leistungsverbraucher als weiteren integrierten Schaltkreis auszuführen. Durch Aktivieren von Teilbereichen des weiteren integrierten Schaltkreises kann die Leistungsaufnahme gesteuert werden.

Ein weiterer Aspekt der Erfindung sieht vor, daß der Leistungsverbrauch der Kombination aus integriertem Schaltkreis und Leistungsverbraucher bei einem Überführen des integrierten Schaltkreises in einen Ruhestand herabgesetzt wird. Dadurch werden Schaltimpulse und Stromstöße auf den Versorgungsleitungen vermieden, die zu Spannungsabfällen der Versorgungsspannung führen könnten.

Weiterhin ist es vorteilhaft, daß die Arbeitsfrequenz des integrierten Schaltkreises bei einem Überführen des integrierten Schaltkreises in einen Ruhezustand herabgesetzt wird. Durch dieses Vorgehen wird die Leistungsaufnahme des integrierten Schaltkreises bei einem Überführen in einen Ruhezustand langsam herabgesetzt und es werden Stromstöße auf den Versorgungsleitungen vermieden.

Weitere Ausgestaltungen der Erfindung sind in den Unteransprüchen angegeben.

Die Erfindung wird nachfolgend anhand von Ausführungsbeispielen näher erläutert.

In den Figuren zeigen:
- Figur 1: eine erfindungsgemäße Anordnung mit einem Lei- stungsverbraucher mit Regelung/Steuerung;
- Figur 2: eine weitere erfindungsgemäße Anordnung mit einem Leistungsverbraucher und einer separaten Rege- lung/Steuerung;
- Figur 3: eine weitere erfindungsgemäße Anordnung mit einem Leistungsverbraucher und einer separaten Rege- lung/Steuerung;
- Figur 4: eine erfindungsgemäße Anordnung zur Frequenzsteue- rung.
- Figur 5: eine weitere erfindungsgemäße Anordnung mit einem Leistungsverbraucher.

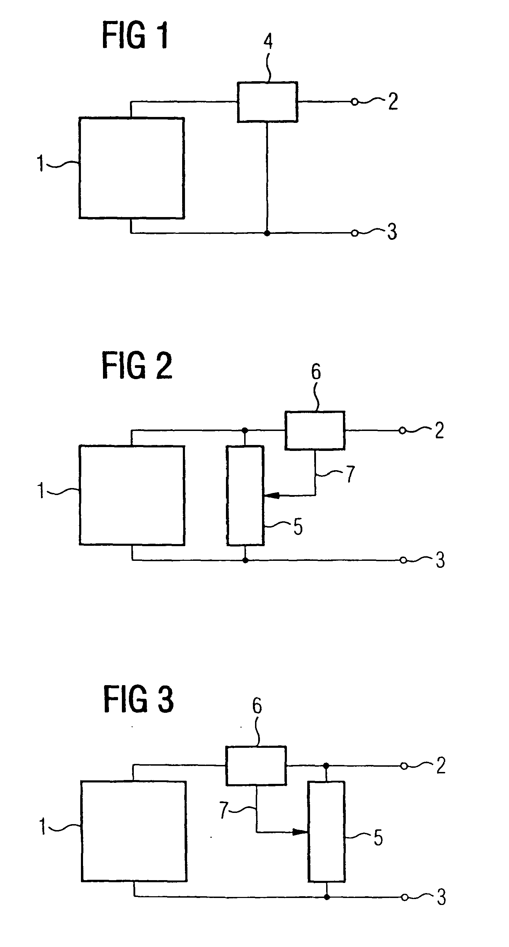

Der in Figur 1 dargestellte integrierte Schaltkreis 1 ist dazu geeignet, den Leistungsverbrauch zwischen einem Versorgungspotential 2 und einem Bezugspotential 3 zumindest zeitweise gleichmäßig zu gestalten. Dies wird dadurch erreicht, daß der Leistungsverbraucher 4 mit integrierter Regelung/Steuerung eine konstante Leistung über das Versorgungspotential 2 aufnimmt und je nach Bedarf an den integrierten Schaltkreis 1 weiterleitet oder direkt verbraucht.

Der Leistungsverbraucher mit Regelung/Steuerung 4 kann dabei als separates Bauelement außerhalb des integrierten Schaltkreises 1 angeordnet sein, oder direkt in dem integrierten Schaltkreis realisiert sein.

Mit Bezug auf Figur 2 ist eine weitere erfindungsgemäße Anordnung dargestellt. Sie besteht aus einem Bezugspotential 3, einem Versorgungspotential 2, sowie einer Regelung/Steuerung 6 für einen Leistungsverbraucher 5, wobei der Leistungsverbraucher 5 über ein Steuersignal 7 gesteuert wird, so daß die vom integrierten Schaltkreis 1 und dem Leistungsverbraucher 5 aufgenommene Leistung zumindest zeitweise gleichmäßig gestaltet ist.

Die Regelung/Steuerung 6 sorgt dafür, daß die von dem integrierten Schaltkreis 1 und dem Leistungsverbraucher 5 aufgenommene Leistung in etwa Konstant ist, so daß die über das Versorgungspotential 2 und das Bezugspotential 3 eingeprägte Leistung zumindest zeitweise gleichmäßig ist. Dazu mißt die Regelung/Steuerung 6 den über das Versorgungspotential 2 eingeprägten Strom und sorgt dafür, daß dieser annähernd konstant ist. Dies wird erreicht, indem über das Steuersignal 7 ein Leistungsverbraucher 5 gesteuert wird.

In Figur 3 ist eine Variante der in Figur 2 dargestellten Anordnung abgebildet, die sich dahingehend von Figur 2 unterscheidet, daß die Regelung/Steuerung 6 lediglich den von dem integrierten Schaltkreis 1 ausgenommenen Strom mißt und nicht wie in Figur 2 den Strom mißt, der sowohl von dem integrierten Schaltkreis als auch von dem Leistungsverbraucher aufgenommen wird. Wiederum steuert die Regelungs/Steuerungseinheit 6 die Leistungsaufnahme des Leistungsverbrauchers 5.

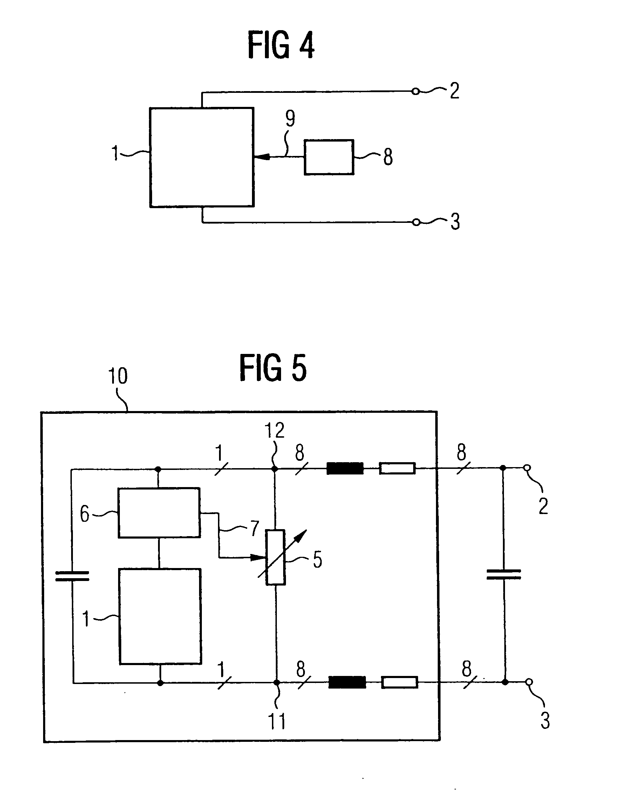

Mit Bezug auf Figur 4 ist eine weitere Variante der erfindungsgemäßen Anordnung dargestellt. Ein integrierter Schaltkreis 1 ist an ein Bezugspotential 3 und an ein Versorgungspotential 2 angeschlossen. Weiterhin ist eine Frequenzsteuerung 8 vorgesehen, die über ein Frequenzsteuersignal 9 die Arbeitsfrequenz des integrierten Schaltkreises 1 steuert. Durch diese Anordnung ist es möglich, die Arbeitsfrequenz des integrierten Schaltkreises 1 an den momentanen Betriebszustand anzupassen. So kann beispielsweise während längerer Ruhephasen des integrierten Schaltkreises 1 die Arbeitsfrequenz des integrierten Schaltkreises 1 langsam heruntergefahren werden, um dadurch Stromstöße auf dem Versorgungspotential 2 zu vermeiden.

In Figur 5 ist ein weiteres Beispiel einer erfindungsgemäßen Anordnung dargestellt. Ein Chip 10 ist an ein Bezugspotential 3 und ein Versorgungspotential 2 angeschlossen. Dabei ist außerhalb des Chips 10 eine Kapazität vorgesehen. In diesem Ausführungsbeispiel verfügt der Chip 10 über 8 Anschlüsse, die an das Versorgungspotential 2 angeschlossen sind und 8 Anschlüsse, die an das Bezugspotential 3 angeschlossen sind. In dem Chip 10 sind die 8 Leitungen für das Bezugspotential durch ein Ersatzschaltbild bestehend aus je einer Spule und je einem Widerstand dargestellt. Ebenso sind die 8 Leitungen für das Versorgungspotential mit je einer Spule und je einem Widerstand als Ersatzschaltbild dargestellt. Die 8 Leitungen des Bezugspotentials 3 sind an einem Masseknoten 11 und die 8 Leitungen des Versorgungspotentials sind an einem Spannungsknoten 12 zusammengeschaltet. Zwischen dem Masseknoten 11 und dem Spannungsknoten 12 ist ein Leistungsverbraucher 5 und eine Kapazität angeordnet. Weiterhin ist an dem Masseknoten 11 eine integrierte Schaltung 1 angeschlossen. Die integrierte Schaltung 1 ist an den Spannungsregulator 6 angeschlossen, der seinerseits an den Spannungsknoten 12 und über das Steuersignal 7 an den Steuermechanismus des Leistungsverbrauchers 5 angeschlossen ist.

In allen obengenannten Ausführungsbeispielen kann der Leistungsverbraucher als steuerbarer Widerstand, als Transistor oder als integrierter Schaltkreis ausgeführt werden. Wird der Leistungsverbraucher als integrierter Schaltkreis ausgeführt, so kann er derlei ausgestaltet sein, daß Schaltungsanordnungen äquivalent zu Anordnungen des integrierten Schaltkreises gebildet werden, die je nach Leistungsverbrauch des integrierten Schaltkreises aktiviert bzw. deaktiviert werden. Hierzu ist z.B. ein Ringoszillator geeignet, der je nach Leistungsverbrauch des integrierten Schaltkreises 1 vergrößert oder verkleinert werden kann, bzw. parallele Ringoszillatoren aktiviert werden können.

## Patentansprüche

1. Schaltungsanordnung zur Regelung des Leistungsverbrauchs eines integrierten Schaltkreises (1), bei der der integrierte Schaltkreis elektrische Kontakte zum Anschließen einer Versorgungsspannung aufweist,
**dadurch gekennzeichnet, dass**
- die Schaltungsanordnung einen in seiner Leistungsaufnahme steuerbaren Leistungsverbraucher (4; 5) aufweist, der zusätzlich zu dem integrierten Schaltkreis Leistung aufnimmt und dessen Leistungsverbrauch von dem Leistungsverbrauch des integrierten Schaltkreises abhängig steuerbar ist,
- wobei der Leistungsverbraucher (4; 5) so gesteuert ist, dass der Leistungsverbrauch des integriertem Schaltkreises (1) und des Leistungsverbrauchers (4; 5) zusammen zumindest zeitweise im Wesentlichen konstant ist,
- wobei der Leistungsverbraucher (4; 5) mehr Leistung aufnimmt, wenn der integrierte Schaltkreis (1) weniger Leistung aufnimmt.

2. Schaltungsanordnung nach Anspruch 1
**dadurch gekennzeichnet, dass**
der Leistungsverbraucher (4; 5) elektrische Energie in Wärmeenergie umwandelt.

3. Schaltungsanordnung nach einem der Ansprüche 1 oder 2,
**dadurch gekennzeichnet, dass**
die Schaltungsanordnung den Leistungsverbraucher (4; 5) so steuert, dass während einer Zeitdauer mit im Wesentlichen konstantem Leistungsverbrauch des Leistungsverbrauchers (4; 5) der Leistungsverbrauch des Leistungsverbrauchers (4; 5) verringert wird.

4. Schaltungsanordnung nach einem der Ansprüche 1 bis 3,
**dadurch gekennzeichnet, dass**
der Leistungsverbraucher (4; 5), eine Leistungsverbrauchersteuerung und/oder eine Leistungsverbraucherregelung in dem integrierten Schaltkreis realisiert ist.

5. Schaltungsanordnung nach einem der Ansprüche 1 bis 4,
**dadurch gekennzeichnet, dass**
der Leistungsverbraucher (4; 5) einen steuerbaren Widerstand, einen Transistor, einen Kondensator und/oder einen weiteren integrierten Schaltkreis umfasst.

6. Schaltungsanordnung nach einem der Ansprüche 1 bis 5,
**dadurch gekennzeichnet, dass**
die Schaltungsanordnung den Leistungsverbrauch der Kombination aus integriertem Schaltkreis (1) und Leistungsverbraucher (4; 5) bei einem Überführen des integrierten Schaltkreises (1) in einen Ruhestand herabsetzt.

7. Schaltungsanordnung nach einem der Ansprüche 1 bis 6,
**dadurch gekennzeichnet, dass**
die Schaltungsanordnung die Arbeitsfrequenz des integrierten Schaltkreises bei einem Überführen des integrierten Schaltkreises (1) in einen Ruhezustand herabsetzt.

## Claims

1. Circuit configuration for regulating the power
consumption of an integrated circuit (1), the integrated circuit (1) comprising electrical contacts for applying a supply voltage,
**characterized in that**
- the circuit configuration comprises a load (4; 5) whose power consumption is controllable, which consumes surplus power in addition to the integrated circuit (1) and whose power consumption is controllable in dependence on the power consumption of the integrated circuit (1),
- wherein the load (4; 5) is controlled such that, at least at times, the power consumption of the integrated circuit (1) and the load (4; 5) combined is substantially constant,
- wherein the load (4; 5) draws more power when the integrated circuit (1) is drawing less power.

2. Circuit configuration according to claim 1,
**characterized in that**
the load (4; 5) converts electrical energy into thermal energy.

3. Circuit configuration according to claim 1 or 2,
**characterized in that**
the circuit configuration regulates the load (4; 5) such that, during a period of time of substantially constant power consumption of the load (4; 5), the power consumption of the load (4; 5) is reduced.

4. Circuit configuration according to one of claims 1 to 3,
**characterized in that**
the load (4; 5), a load controller and/or a load regulator is formed in the integrated circuit.

5. Circuit configuration according to one of claims 1 to 4,
**characterized in that**
the load (4; 5) comprises a controllable resistor, a transistor, a capacitor and/or a further integrated circuit.

6. Circuit configuration according to one of claims 1 to 5,
**characterized in that**
the circuit configuration lowers the power consumption of a combination of the integrated circuit (1) and the load when transferring the integrated circuit (1) to an idle state.

7. Circuit configuration according to one of claims 1 to 6,
**characterized in that**
the circuit configuration lowers the operating frequency of the integrated circuit when transferring the integrated circuit (1) to an idle state.

## Revendications

1. Montage de commutation destiné à réguler la consommation de puissance d'un circuit intégré (1), où le circuit intégré présente des contacts électriques pour le raccordement d'une tension d'alimentation, **caractérisé en ce que**
- le montage de commutation présente un consommateur de puissance (4 ; 5) pilotable dans son absorption de puissance, qui absorbe de la puissance en plus du circuit intégré et dont la consommation de puissance est pilotable en fonction de la consommation de puissance du circuit intégré,
- où le consommateur de puissance (4 ; 5) est piloté de telle sorte que la consommation de puissance du circuit intégré (1) et du consommateur de puissance (4 ; 5) ensemble soit, du moins par moments, sensiblement constante,
- où le consommateur de puissance (4 ; 5) absorbe plus de puissance quand le circuit intégré (1) absorbe moins de puissance.

2. Montage de commutation selon la revendication 1,
**caractérisé en ce que**
le consommateur de puissance (4 ; 5) convertit de l'énergie électrique en énergie calorifique.

3. Montage de commutation selon l'une des revendications 1 ou 2,
**caractérisé en ce que**
le montage de commutation pilote le consommateur de puissance (4 ; 5) de telle sorte que, pendant une période à consommation de puissance sensiblement constante du consommateur de puissance (4 ; 5), la consommation de puissance du consommateur de puissance (4 ; 5) soit réduite.

4. Montage de commutation selon l'une des revendications 1 à 3,
**caractérisé en ce que**
le consommateur de puissance (4 ; 5), une commande de consommateur de puissance et/ou une régulation de consommateur de puissance est réalisée dans le circuit intégré.

5. Montage de commutation selon l'une des revendications 1 à 4,
**caractérisé en ce que**
le consommateur de puissance (4 ; 5) comprend une résistance pilotable, un transistor, un condensateur et/ou un circuit intégré supplémentaire.

6. Montage de commutation selon l'une des revendications 1 à 5,
**caractérisé en ce que**
le montage de commutation abaisse la consommation de puissance de la combinaison constituée du circuit intégré (1) et du consommateur de puissance (4 ; 5) en cas de transposition du circuit intégré (1) dans un état de repos.

7. Montage de commutation selon l'une des revendications 1 à 6,
**caractérisé en ce que**
le montage de commutation abaisse la fréquence de travail du circuit intégré en cas de transposition du circuit intégré (1) dans un état de repos.
